# EUROPEAN PATENT SPECIFICATION

(11) **EP 0 428 681 B1**
(45) Date of publication and mention of the grant of the patent: **31.03.1999**
(21) Application number: 90908839.5
(22) Date of filing: 14.05.1990
(51) Int. Cl.: H05K 1/14, H01R 9/09, H01R 13/642, H01R 13/33, H01R 11/09, H01R 13/622, H01R 4/58

(54) **IMPROVED ELECTRICAL CONNECTORS AND IC CHIP TESTER EMBODYING SAME**
VERBESSERTE ELEKTRISCHE VERBINDUNGEN FÜR IC-CHIP-TESTER
CONNECTEURS ELECTRIQUES AMELIORES ET TESTEUR DE PUCES DE CIRCUITS INTEGRES LES METTANT EN OEUVRE

(30) Priority: 09.06.1989 US 364343
(43) Date of publication of application: 29.05.1991
(73) Proprietor: LABINAL COMPONENTS AND SYSTEMS, INC., Elk Grove Village Illinois 60007 (US)
(72) Inventor: SHAH, Arun, Jayantilal, Hanover Park, IL 60103 (US); McCLUNG, David, William, Bridgeview, IL 60455 (US); HOPFER, Albert, N., Park Ridge, IL 60068 (US); LINDEMAN, Richard, J., Wood Dale, IL 60191 (US); ZAFAR, Saeed, Park Ridge, IL 60068 (US)
(74) Representative: Hoeger, Stellrecht & Partner
(86) International application number: US9002875
(87) International publication number: WO9015517

(56) References cited:
- EP-A- 0 248 521
- EP-A- 0 314 481
- US-A- 4 029 375
- US-A- 4 236 776
- US-A- 4 581 679
- US-A- 4 620 761
- US-A- 4 707 657
- PATENT ABSTRACTS OF JAPAN, vol. 12, no. 7 (E-571)[2854], 9th January 1988; & JP-A-62 165 958 (HITACHI) 22-07-1987

## Description

### Field Of The Invention

This invention relates to improved electrical connectors for electrical components, and more particularly pertains to an improved device for testing integrated-circuit (IC) chips.

### Background Of The Invention

IC chips are well known in the art and are in a continual state of development. Such chips may contain thousands of microscopic circuit elements and transistors, resistors, etc. Such elements are interconnected within the IC chip in various circuit configurations, and have input/output circuit leads. The chips typically are mounted in chip carriers with these input/output leads connected to conductive areas or pads which may be located about the chip carrier outer periphery or in various patterns across the bottom surface such as on land grid arrays.

The various chip circuits are desirably tested prior to installation in an electronic device to insure proper functioning thereof. Replacement of a faulty chip following installation in a device is both time-consuming and expensive. Accordingly, defective chips must be discovered and discarded if at all possible, prior to installation. Testing is thus seen to be a mandatory preliminary step, particularly as the increasing complexity of IC chips results in a high-percentage failure rate. This testing normally includes circuit testing after the chip is mounted in the chip carrier by contacting the pads on the carrier with suitable test apparatus. Thus the testing and apparatus referred to hereinafter is discussed herein in terms of effecting testing contacts with the chip carrier.

The prior art has employed chip testers using metal on elastomers for conducting signals from a printed circuit trace to an IC chip carrier pad of the chip to be tested. Such elastomers however have a very limited working life and are readily damaged or deteriorate following several test cycles, requiring replacement. Obviously the testing process becomes extremely expensive when thousands of chips are tested daily on a regular basis.

Examples of prior art utilization of such conductive elastomers for use in connectors comprise Buchoff et al. U.S. Pat. 3,971,610 of July 27, 1976 and Fahling U.S. Pat. 4,360,858 of November 23, 1982.

In accordance with this invention at least one connector comprising a wadded conductive wire button in combination with a conductive plunger is mounted in an apertured insulator board for establishing electrical contact between the pads of a chip and the circuit traces of a PC test board.

The wadded wire adapted to engage the trace of a PC board is resiliently deformable when compressed between the trace and the base of the plunger. The plunger distal end projects from the insulator opening on which disposed for purposes of effecting substantially a point contact with a chip carrier pad by the resilient force of the button.

The use of such wadded wire conductor buttons per se in mounting boards for effecting electrical connections is shown in the prior patent art as in Smolley U.S. Pats. 4,574,331 of March 4, 1986 and 4,581,679 of April 8, 1986. Also, the use of such wadded wire buttons in testing apparatus is disclosed in Smolley U.S. Pat. 4,733,172 of March 22, 1988 in which opposed ends of the disclosed buttons are seen to engage a chip pad and a contact area of a test circuit board.

It has been found however that in the course of relative movement between an end portion of a wadded contact button protruding from a carrier board and a trace of a PC board in the course of effecting repeated desired button-pad location and contact, the wire of the button tends to unravel and cause shorting with an adjacent circuit. Such unraveling also results in non-uniform button-conductor contacts and resultant conductivity inconsistency. Thus it has been found that engagement with loose wire ends of a button contact with an engaging conductive surface will result in undesired increased resistance to current passage.

EP-A-0 248 521 discloses an electrical connector for testing high frequency integrated circuits, said connector comprising dielectric housing means in the form of a stack of three boards made of dielectric material, and a plurality of electrically conductive contact assemblies disposed in apertures traversing said housing means and extending between opposed surfaces thereof. Each of the apertures is made up by aperture portions of equal diameter provided in the outer boards and an aperture portion of greater diameter in the intermediate board, all three aperture portions being axially aligned. Each of the contact assemblies consists of two outer plunger-type contact elements with a plunger portion axially guided in the aperture portion of one of said outer boards and an enlarged base portion being disposed in the enlarged aperture portion of the intermediate board, and of a resiliently deformable contact element in the form of a wadded strand of conductive wire disposed within the aperture portion of the intermediate board for being axially compressed by the base portions of the plunger-type contact elements. The diameter of the enlarged base portions of the plunger-type contact elements is smaller than the diameter of the aperture portion provided in the intermediate board, and the lengths of said contact elements is such that their plunger portions always project beyond the opposed surfaces of the housing means even when the resilient contact element is extremely compressed.

It is an object of the present invention to provide an electrical connector, in particular an electrical connector for use in an integrated circuit chip tester, which electrical connector employs a wadded wire contact element able to effect in excess of 25000 connect-disconnect cycles without the need for contact replacement.

This object is achieved by an electrical connector as defined in claim 1 or in claim 5, preferred embodiments of the inventive electrical connector being defined in one or several of claims 2 to 4 and 6 to 26.

The second conductive contact element of the electrical connector of this invention is preferably in the form of a plunger-type contact element which engages an associated button disposed within a carrier board at its inner end, and engages a pad of a chip carrier by means of the rounded end of a needle-like projection extending exteriorly of a carrier board in which the plunger is mounted. The latter carrier-plunger contact effects negligible wear on the plunger and the resiliency of the wire button contact assures desired long extended life of the button-plunger contact combination. The button-engaging plunger may assume other configurations for effecting a low resistance contact as for instance a rounded dome-like projecting portion.

In the various button plunger arrangements care must be taken to design the button-receiving aperture of the button board or carrier so as to allow the button to freely compress and expand in the normal course of urging the plunger contact portion into engagement with a conductive pad or the like. Impairment of the spring action of the wadded wire buttons would adversely affect the positioning of the button ends causing variances in the compressive engagement of the button with resultant unpredictability of the resistance through the resulting button interface.

The connector according to the invention is suitable for use in a chip tester of low inductance particularly adapted for high frequency applications, having been successfully tested at 1.5 gigahertz. This is made possible by the low resistance and low inductive electrical path provided by each of the tester contacts hereinafter disclosed.

Preferred embodiments of this invention provide a button-plunger contact assembly which is particularly suited for rapid connect-disconnect operation and where high signal propagation is desired.

Thus in accordance with one embodiment of this invention a chip tester is provided comprising super-imposed apertured insulator boards. In a first board projecting plungers are mounted for effecting substantially point contact with the pads of carriers of IC chips to be tested. In a second insulator board, wadded wire contact buttons are mounted in the apertures thereof and the opposed ends thereof project from opposed surfaces of the board in which the buttons are mounted. The buttons may thus project into the apertures of the overlying plunger board and resiliently bias the terminal plunger contact ends exteriorly of the first board.

The plunger ends may effect substantially point contacts with the pads of a chip carrier to be tested, and the button end portion projecting from the bottom of the second insulator board may effect desired contact with the trace of a test PC board.

With appropriate assembly techniques or sequences, the provided plunger-button contact portions may be disposed in the apertures of a single board and work to equal advantage.

In a modified plunger-button construction particularly adapted for quick make-and-break of electrical contacts, a wadded wire button contact is disposed in an aperture of an insulator housing and engages contact plungers at opposed button ends. The plungers have pin-like pad-engaging terminal contacts which are resiliently biased by the button contacts to project from the housing apertures in which disposed. The opposed plunger contacts may thus readily effect contacts with the contact pads or traces of PC boards or chips to be interconnected when said pads or traces are urged against the resiliently biased plungers, as will hereinafter be described in greater detail.

In the various button and button board embodiments hereafter described, the buttons are desirably retained in button board openings in such manner as to ensure the necessary button resiliency utilized in the normal course of button operation.

The above invention will become more apparent from the following detailed description when read in light of the accompanying drawings wherein:
Fig. 1 is an exploded view of an IC tester made in accordance with this invention;
Fig. 2 is a fragmentary sectional view, partly in elevation of the chip tester of Fig. 1 in the normal course of operation and illustrated on a scale enlarged over that of Fig. 1;
Fig. 3 is an enlarged sectional view illustrating the test path present in the chip tester of Figs. 1 and 2 in the normal course of operation thereof;
Fig. 3A is an enlarged sectional view similar to Fig. 3 in which the contact button and plunger are mounted in a unitary mounting board, which may be utilized in some circumstances;
Fig. 4 is a plan view of the chip socket employed in the chip tester of Figs. 1 and 2;
Fig. 4A is a perspective view of a chip-centering clip employed in the corners of the socket of Fig. 4;
Fig. 4B is a sectional view illustrating the manner in which the clip of Fig. 4A is secured in place in the socket of Fig. 4;
Fig. 5 is a plan view of a button carrier board employed in the chip tester of Figs. 1 and 2;
Fig. 6 is an enlarged sectional view, partly in elevation, illustrating a modified contact and board arrangement employed in effecting contact between spaced printed circuit boards by a double plunger means;
Fig. 6A is a view similar to Fig. 6 in which a double-plunger and button contact arrangement as in Fig. 6 is in the process of being assembled;
Fig. 7 is a fragmentary plan view of the connection between a flex circuit and a probe card employed in the testing of integrated circuit devices;
Fig. 7A is a fragmentary sectional view illustrating a button plunger contact made in accordance with this invention particularly adapted for use in automatic testing of integrated circuits and taken on line 7A-7A of Fig. 7.
Fig. 8 is a plan view of a modified land grid array socket employing plunger button contacts made in accordance with this invention;
Fig. 9 is a sectional view taken on line 9-9 of Fig. 8;
Fig. 10 is a perspective view of the land grid array socket of Figs. 8 and 9; and
Fig. 11 is a sectional view of a modified button plunger construction illustrating a modified plunger in combination with an elongate wadded wire button.

### Description Of The Invention

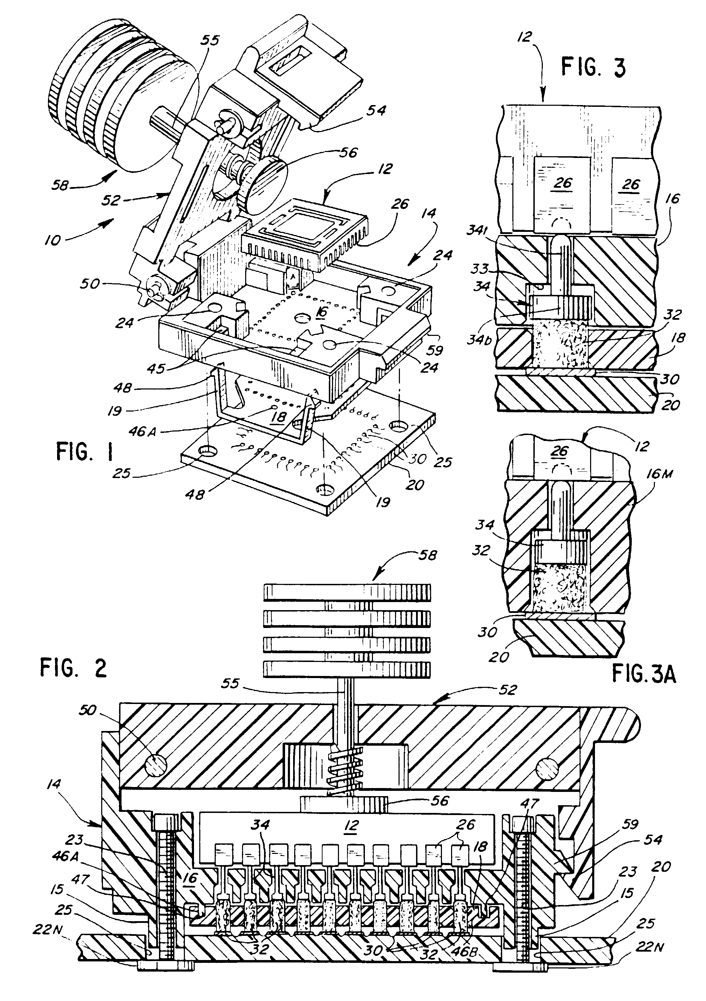

Referring now more particularly to Fig. 1 of the drawing, an exploded view is illustrated of a tester 10 adapted to receive a chip carrier 12 during a chip test cycle. The chip itself is not shown, being concealed within the carrier as noted above. The chip carrier 12 is receivable in socket 14 of the tester 10 on the upper surface of a plunger board 16. A button carrier board 18 having four attaching legs 19 is adapted to effect a snap latching engagement in four corner portions of the socket 14 and simultaneously be resiliently biased against the under surface of the plungers contained in board 16 in the normal course of assembly illustrated in Fig. 3. The button carrier board 18 has a printed circuit test board (PCB) 20 urged against its lower surface by means of assembly cap screw bolts 22 shown in Fig. 2. The bolts 22 traverse four corner openings 24 of the socket 14 seen in Fig. 1, through alignment bosses 15 (Fig. 2), and protrude through openings 25 of the circuit board 20 and are engaged by nuts 22N which abut the underside of the board 20, rendering the test board 20, button carrier board 18 and socket 14 in a rigid compressive state of assembly. The bosses or pins 15 and openings 25 serve as alignment means, to insure proper registry of the respective contact elements 30 and buttons 32.

As above noted, an IC chip may contain thousands of microscopic electrical circuit elements. The output/input leads for the various circuits are connected to conductive pads normally disposed about the periphery of the carrier 12. Thus, in Figs. 1 and 3, it will be noted that the carrier 12 has a plurality of contact pads 26 which are disposed about the periphery of its bottom surface. Three of such pads being illustrated on an enlarged scale in Fig. 3. As was also above pointed out, in view of the complexity of chips employed today, a high percentage of chips manufactured possess some defect which, if uncovered following installation in an electronic device, would lead to costly and time consuming replacement and repair of such device. Accordingly, it is of great importance that the chips be tested as satisfactory when used in conjunction with circuitry of a test board such as test board 20 illustrated in Figs. 1-3 so as to function satisfactorily for all purposes in the circuitry of a device in which the chip is to be installed.

An invention of this application may be readily appreciated from an examination of the sectional view of Fig. 3. The latter illustrates test board 20 having a trace 30 representing circuitry for testing the chip in carrier 12, e.g., representing circuitry in which the chip is normally to be employed. In accordance with this invention, electrical communication is established between the test board circuitry 30 and the pads 26 of carrier 12 by means of interconnecting compressible wire buttons 32 mounted in button board 18 and electrically conductive plungers 34 reciprocally mounted in plunger board 16.

In chip testers of the prior art, conductive elastomers are mounted in insulating boards for purposes of effecting electrical communication between a trace or pad on a test printed circuit board and a chip pad. Also, as above noted, use of conductive buttons 32 for purposes of effecting electrical connections is known in the art. Such buttons are preferably formed from a single strand of metal wire with each strand being wadded together to form a nearly cylindrical button. Each wadded wire connector 32 is formed so as to fit within its receiving opening in the button board 18 as illustrated in Figs. 2 and 3 so as not to be frictionally gripped thereby so as to restrict its ability to function as a resilient spring member. It will be noted from Figs. 2 and 3 that in those board button combinations in which the buttons 32 project from a board surface, the button-receiving opening on such surface preferably is chamfered or enlarged. Such enlargement not only facilitates entry of a button if inserted from such surface but provides space assuring retention of the buttons within the limits of the board opening despite any button "mushrooming," off-center shifting of the button ends during compression or the presence of loosened strands at the button ends. During button compression and operation of the contacts, the traces or pads preferably abut against the board surfaces as illustrated in the drawings. Also as illustrated in Fig. 3 a carrier board 18 may have a central button-engaging restriction portion R to retain the button along a central restricted annulus while allowing opposed elongate end portions of the buttons to freely compress and expand. Any button board opening design may be employed which allows desired resiliency of the buttons without gripping of the buttons so as to impair this necessary compression and expansion function. As a result, uniform button resilience and contacting is effected with resulting desired uniformity of conductivity.

The openings in the button engaging boards such as boards 18 (and 16) of Fig. 3 may be formed by injection molding of appropriate insulating materials in dies of suitable configurations to provide the openings as the boards are molded. An example of suitable materials is polyphenelene sulfide such as sold by Phillips Petroleum Company under the tradename Ryton. Molding assures smooth aperture peripheries avoiding undesired button snagging or hangup. Fillers may be employed for strength enhancement.

Button receiving openings may also be drilled in appropriate dielectric boards, and the chamfers may be formed by appropriate drilling or reaming of the aperture ends.

Each button 32 is so sized as to protrude slightly above and slightly below the carrier board 18 in which disposed. Each button 32 effects electrical contact at multiple points with pad 30 of test board 20 at its cylindrical base and, at its opposed button end, effects similar electrical contact with the base of the respective plunger contact 34. Wadded wire button contacts such as contacts 32 provide significant operational advantages not present in other types of connections such as soldered connections. The connections provided thereby are of high integrity and reliability and have very few associated variables which may affect the quality of the electrical connection of which comprising a part. The only significant variables in contacts formed by buttons 32 are the size of the button itself and the compressive force which may be applied thereto in the course of effecting the interconnection between the opposed conductors of the connection in which the button comprises an intermediate element.

The buttons 32 are preferably formed from wire fabricated from copper alloys such as beryllium and copper, silver and copper, or copper-nickel-tin. It is apparent that when such buttons are placed under compression, they effect multiple contacts with the opposed contact areas providing multiple conductive paths. The wadded wire buttons are so formed they are substantially resilient so that when subjected to a compressive force, each button has a tendency to return to substantially its original shape. The wadded wire connectors 34 may be of the type marketed by the Cinch Division of Labinal Components and Systems, Inc., of Elk Grove Village, Illinois, under the trademark CIN::APSE. Similar suitable buttons are available from other commercial sources.

In the normal course of use of the tester 10, the chip carrier is mounted in the recessed socket 14, the bottom of which comprises of plunger board 16 in which metallic plungers 34 are mounted for reciprocal movement. Each plunger may be formed of a durable electrically conductive metal, which is preferably coated with 200 micro inches of nickel and 100 micro inches of gold to enhance its durability. It is apparent in Fig. 3 that each plunger 34 has an enlarged cylindrical base portion 34b as well as an attached cylindrical bullet-shaped terminal portion 34t of lesser diameter having a rounded end limit to effect substantially a point contact with the engaged pad 26.

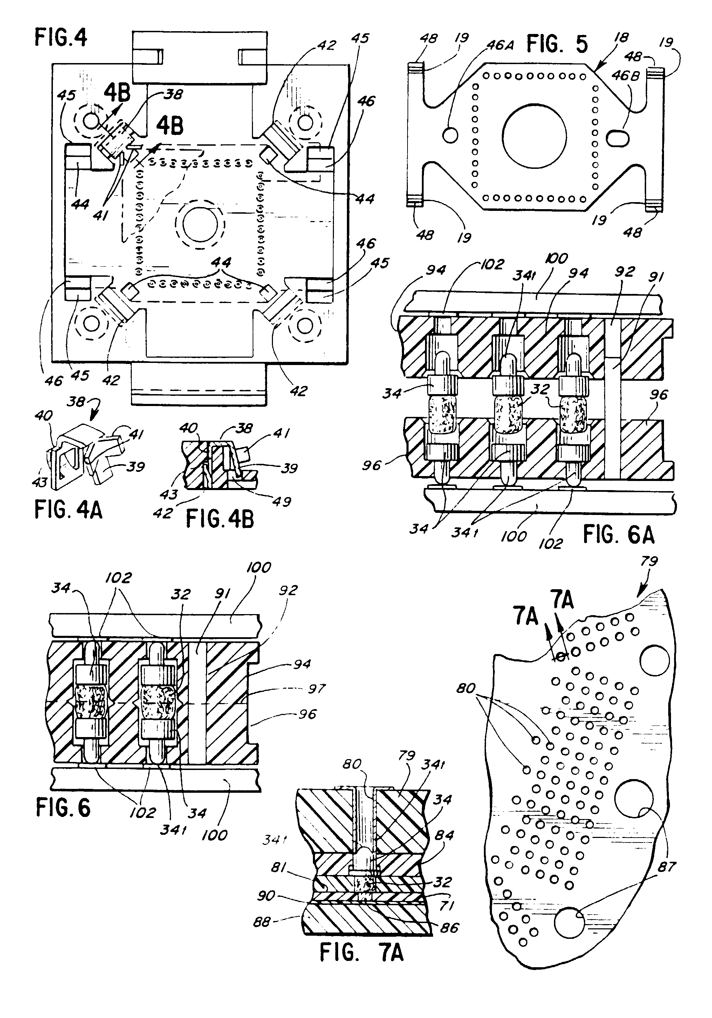

It will be noted from Fig. 4 that each corner portion of the socket 14 has mounted therein a clip 38 seen in perspective in Fig. 4A. Each clip 38 has a mounting leg 40 which is received in a recess 42 in the socket whereby it is retained and locked in position therewith either by means of a tang 43 (see Fig. 4B) or by an appropriate adhesive. Tang 43 snaps into interlocking engagement with a mating ledge portion of the socket recess in which it is disposed. A spring finger 39, resiliently joined to the mounting leg 40 by an intervening bight portion, extends angularly inward and downward at the respective corner of the carrier-receiving cavity of the socket 14. These fingers are positioned to resiliently engage the carrier at its corners and center it in proper alignment in the socket cavity. A pair of tabs or wings 41 formed outward on the engagement leg 39 preferably define a right angular receiver to engage the respective corner of the carrier 12. Three of the recesses 42 for reception of the spring clips 38 are seen in the top plan view of Fig. 4 prior to insertion of mounting and centering springs 38; a clip 38 being shown in assembled position in the fourth corner. The outer end of leg 39 is engaged in a slot 44 in the socket for alignment and retention purposes (see Fig. 4B).

The button board or carrier 18 is snap latched into engagement against the under surface of socket 14 by means of its four flexible latching arms 19 having terminal latch portions 48. Referring further to Fig. 4, as well as Figs. 1 and 2, the socket 14 includes four apertures 46 for receiving the attaching legs 19 of the button board 18 and shoulders 45 for latching engagement by the detent shoulders 48 at the outer ends of those legs. The legs 19 are slightly divergent (see Fig. 1) and resilient to effect snap latching engagement on the shoulders 45. Referring to Figs. 1, 2 and 5, alignment means are provided by way of an aperture 46A and a slot 46B in board 18 and mating depending pins 47 on the socket to effect proper registry of the button board 18 with the plunger board section 16. These components provide attachment and alignment of the button board, and attendant retention of the plungers 34 in the plunger board section 16, prior to attachment of the testing assembly 10 to the test circuit board 20. The latching arms 19 may be replaced by other securement means to maintain the elements of the tester unit in a desired state of assembly. For example, button board 18 may also be received in a press fit in a mating recess in the bottom of the plunger board 16.

Prior to insertion of chip carrier 12, the plunger board section 16 of socket 14 is already in desired compressive engagement with underlying buttons 32 and button board 18 as well as the test printed circuit board 20 in the assembled relationship illustrated in Fig. 2. As earlier noted, the entire assembly is maintained in a compressive state following threaded engagement of the nuts 22N on the assembly bolts 22, urging the test circuit board 20 upwardly against the bottom of the button board or carrier 18 seen in Fig. 5.

During chip testing the circuit test board 20 and button board 18 are in assembled relationship with the plunger housing 16, with the chip carrier 12 urged into desired centered relationship in the socket 14 by corner springs 38. In such centered position the chip carrier is in supported engagement on top of the plungers 34. Cover 52 is then pivoted downwardly from the position of Fig. 1 of the drawing into the position overlying carrier 12. A spring-loaded plunger 55 has an enlarged base portion 56 comprising a component of a heat sink 58 and biases the chip carrier 12 into desired engagement with the underlying projecting terminal portions 34t of the plungers 34 mounted in housing portion 16 comprising the floor of socket 14. Prior to downward movement of the hinged cover 52 which pivotally moves about pivot axis 50, the upper plunger terminal portions 34t are in the dotted line position illustrated in Fig. 3 as a result of the uncompressed conditions of the wadded wire contacts 32. The uncompressed buttons 32 thus upwardly bias plungers 34 toward a limit portion where the upper surface portions of the base portions 34b strike the upper counterbore surfaces 33 of the plunger recesses in which the plungers 34 are disposed. Downward pivotal movement of the tester cover 52 forces the bottom of the carrier contact pads 26 to downwardly move the plunger contacts 34, simultaneously compressing the underlying button contacts 32 into the condition illustrated in Fig. 3. The latter compressed condition assures a desired low resistance, low inductance, high speed electrical connection between the bottom of each chip pad 26 and its associated trace 30 of the test printed circuit board 20. The cover 42 may have means such as latch 54 which effects a snap-lock engagement with mating latch portion 59 of the socket 14 as clearly illustrated in Fig. 2.

After a chip 12 has been tested, the tester cover 52 may be readily unlatched from the socket 14 and pivotally moved upwardly and into the position of Fig. 1 for removal of the carrier with the tested chip and insertion of a new chip carrier. As the test circuit board 20, button board 18 and socket 14 need not be disturbed for the testing of subsequent chips, a succession of carriers may be readily inserted for testing of the carried chips without disturbing any portion of the assembly of Fig. 3 below the lower surface of the carrier 12.

The bottom of the socket 14 of the tester 10 may have housed therein not only the plungers 34 but also the buttons 32. Fig. 3A illustrates a unitary board 16M housing both button contacts 32 and plungers 34. This would require that the board 20 be attached, or other means provided, for retention of the buttons and plungers in oversize apertures in board 16M. Similarly, the bottom of the socket 14 may be a thin apertured sheet against which a discrete plunger board and a discrete carrier board and test circuit board may be urged and retained in a condition of assembly by means such as the illustrated assembly bolts 22 or other securing means.

It has been found that if buttons 32 are employed for purposes of effecting direct communication between test circuit board pads 30 and carrier pads 26, the horizontal movement of chip carriers during positioning to the desired location in socket 14 will tend to gradually unravel the upper surface of buttons 32. Such wire unraveling could lead to possible shorting between adjacent pads 26, which in many instances are spaced only a few mils apart, and interfere with the establishing of a desired uniform contact between the pads 26 and the tops of the contact buttons.

In accordance with this invention, by utilization of a two-piece intermediate connector comprising the button 32 and plunger contact 34 between the traces of the test circuit board and the chip contacts, desired uniform electrical communication is established between the board 20 and the chip carrier 12. The only contact effected between each plunger and an engaged pad 26 is in the nature of a point contact under compression. The carrier in the normal course of being located in the recess of the socket 14 of the tester 10 may readily slidably move relative to an engaged plunger terminal contact portion 34t without any damage whatsoever to its engaged, associated button contact 32.

It will be appreciated, for instance, that during the pivotal downward movement of the hinged cover 52 of the tester 10 of Fig. 1, engagement between the base 56 of the spring loaded heat sink 58 and the upper surface of the carrier 12 would normally effect a force component of movement tending to slidably move the carrier 12 away from the pivot axis 50. Such force component has no adverse effect on each contact made between the terminal portion 34t of each plunger contact 34 and each pad 26. However, if the contact were effected directly between a pad 26 and the upper surface of a wadded wire contact 32, such relative slidable movement would have a tendency to unravel the wadded wire upper surface of each contact button 32, leading to the undesired shorting problem and inefficient engagement previously noted.

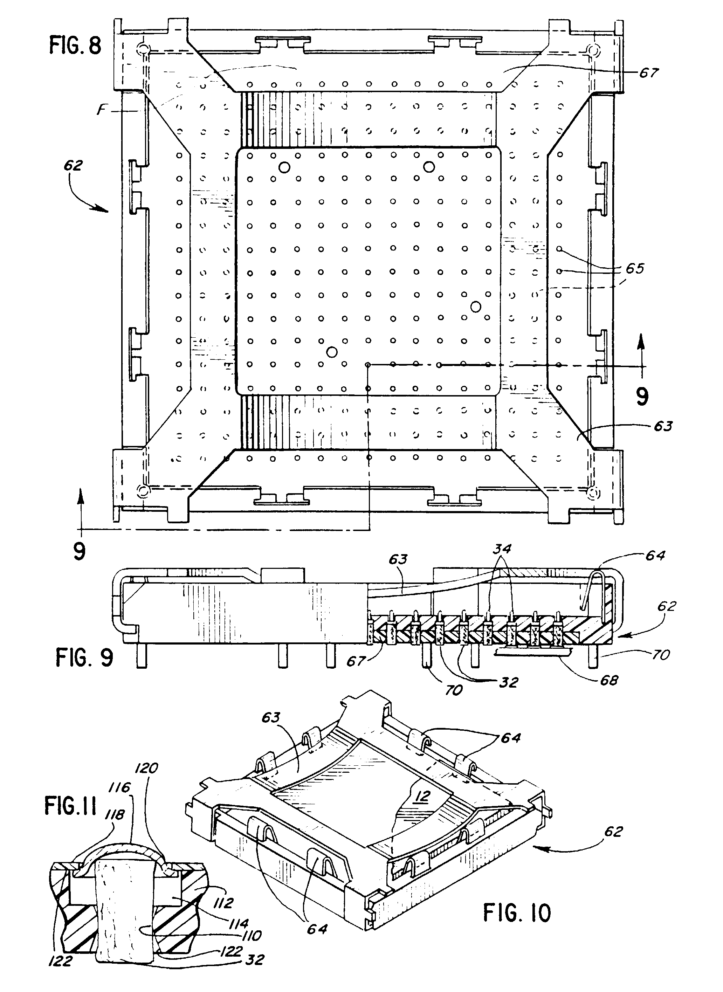

The arrangement of Figs. 8 through 10 comprises a working carrier mount and connector assembly in which a grid array in the button board provides for various conductive paths between a variety of board traces and overlying chip pads. Fig. 8 illustrates a chip mounting device in which a chip carrier such as carrier 12 (fragmentarily illustrated in Fig. 10) is adapted to be centered in a socket body 62 having a plurality of centering clips 64 disposed about the periphery of the socket body. Plunger openings 65 are formed in an array in bottom of socket 62 so as to accommodate various pad arrangements of land grid array carriers adapted to be mounted in socket 62. After the carrier is centered in the socket body by means of inverted U-shaped springs 64, an overlying retention spring 63 which is interlocked to peripheral portions of the socket 62 as illustrated in Fig. 10 urges the chip carrier 12 downwardly with a desired, predetermined biasing force against underlying plunger contacts 34 and subjacent wadded wire buttons 32. The distal terminal portions 34t of the plungers 34 are depressed and the buttons 32 compressed following chip insertion into the socket.

The plunger contacts 34 in Figs. 8 and 9 are arranged in grid array wherein the desired plunger contacts and their associated button contacts 32 may be employed for purposes of effecting desired interconnection between traces of a circuit board 68 and the bottoms of the buttons 32 as illustrated in Fig. 9. It will be noted from Fig. 9 that the buttons 32 may be detachably associated with socket 62 for ready button replacement if and when necessary by a replaceable housing board 67 which may interlock in a bottom recess of the socket 62 by means of a press fit or equivalent means of detachable securement.

The socket button board assembly of Fig. 9 may be readily mounted to a printed circuit board by means of alignment and mounting posts 70. The posts may be received in a friction interference fit in corresponding mounting openings of such circuit boards such as circuit board 68.

The sectional view of Fig. 7A comprises a section taken on line 7A-7A through an opening of an assembly including probe card 79 illustrated in plan view in Fig. 7. Figure 7A illustrates an assembly wherein wadded wire button contacts 32 and associated plunger contacts 34 of this invention may be employed for purposes of effecting contact in electrical communication with plated through openings such as illustrated openings 80 of probe card 79, the latter being mounted over a plunger board 84 having compressible contact buttons 32 engaging the bottom thereof. The resiliency of buttons 32 mounted in board 81 urges engaged plunger contacts 34 against the end of the plated through openings 80 for purposes of effecting electrical communication between the probe card circuitry and circuitry 86 of a flexible substrate 71. The outer end 34t of the button is generally dome-shaped and of a diameter greater than the diameter of the plated through opening and insures good electrical contact with the hole plating. The bottoms of the button contacts 32 are in engagement with the flex circuit 86 as illustrated. For purposes of maintaining the probe card and flex circuit in desired alignment, aligning pins (not illustrated) traversing openings such as openings 87 of Fig. 7 may be employed. The entire assembly may be mounted above a rigid backing plate such as plate 88 of Fig. 7 on which an insulating layer 90 is disposed to insulate the rigidifying backing plate 88 from the conductor contacts 32 mounted in the button board.

Another application of the novel wadded wire buttons and plunger contacts of this invention is seen in Figs. 6 and 6A of the drawing wherein it will be noted that opposed plunger boards 94 and 96 may have spaced plungers 34 mounted therein at opposed ends of compressible wadded wire contacts 32. Fig. 6A is an exploded view of this connector arrangement, as in the course of assembly. This double plunger contact assembly may be used to advantage for ready connect-disconnect operations between engaged circuits or traces of spaced printed circuit boards such as printed circuit boards 100 having traces 102. The size of the wadded wire buttons 32 is such relative to the receiving openings in the opposed boards 94 and 96 that desired resilient engagement is made between the plunger contacts 34 as they are urged into compressive engagement with the spaced boards 96 and 94, simultaneously compressing the wadded wire buttons therebetween. Terminal contact portions 34t of the plunger contacts 34 may be urged into compressive engagement with the traces 102, thus effecting good electrical contact between the spaced printed circuit boards. Contact may be readily broken by removing either printed circuit board.

A knurled pin 91 is force-fit in holes 92 of the two boards for alignment and retention purposes. The two discrete boards 94 and 96 also may be joined as by sonic welding or adhesives along juncture line 97 to effectively form a single "board" 95 for permanently capturing the buttons and plungers as in Fig. 6. When the buttons 32 are captured within the board 95 no chamfering of the button openings is necessary to compensate for "mushrooming" exteriorly of the boards. The buttons must be so sized relative to the openings in which the buttons and plungers are disposed so as to assure free button compression and expansion. The board apertures in which the buttons are disposed may of course be of any desired configuration to accommodate desired button expansion.

Figure 11 demonstrates another variety of plunger configuration will work to advantage in the novel connectors of this invention. Figure 11 illustrates a button 32 mounted in an opening 110 extending through a button carrier board 112, with the lower button end exposed for engagement with an appropriate contact component such as a PC board pad or trace. The upper button end portion extends through a large counterbore opening 114 which also accommodates a dome-shaped contact element 116 arranged over the upper end of the button 32. The dome-shaped contact 116 is reciprocally movable within the opening 114. A retainer sheet 118, with an opening 120 therein which is smaller than the outer diameter of the flange portion of the contact 116, is bonded to the top surface of the board 112 and overlaps the flange 110 of the contact 116 to capture the contact and retain it in position on the wadded button 32 for its reciprocal movement. Enlarged portions of the opening 110, including chamfered portion 122 and the counterbore section 114, provide freedom of compressive movement of the respective end portions of the button 32 and the other attendant advantages noted above. Plungers 116 may be readily stamped from a mother sheet and readily assembled in large numbers in the button carrier board 112.

It is thus seen that novel plunger-wadded wire button connector assemblies have been provided in which the full benefits of the wadded wire contacts are obtained in applications such as chip testing and other repetitive circuitry contact situations without destructive consequences to the wadded wire contacts. The provided assemblies isolate an end of a wadded wire button contact from forces tending to disintegrate or unravel such wadded wire button end. As above noted, such unraveling would have a tendency to result in shorting in the course of contacting applications wherein the intervals between the conducting trace or pad surfaces are extremely small. The wadded wire button contacts of the disclosed connectors and testers are extremely durable in compression and are relatively inexpensive to manufacture. Because of the short intervals between the connected circuits of the chip carrier and circuit board, signal distortion occasioned by inductance is substantially eliminated. The point contacts affected by the plunger contacts provide ready relative movement between an engaged pad or trace without any resulting structural damage. As the contacts effected by the plunger contacts are in the nature of point contacts the alignment tolerances of the chip pads or circuit traces or pads relative to the plunger contact is increased.

As above noted, many structural changes and alternative arrangements may be employed without departing from the invention as claimed. Accordingly, it is intended that this invention be limited only by the scope of the appended claims.

## Claims

1. An electrical connector comprising:
a dielectric housing means (16, 18) having contact elements (32, 34) mounted therein and having opposed first and second surfaces for assembly with opposed conductors (26, 30) for electrical interconnection between said conductors, said housing means (16, 18) having at least one prearranged aperture traversing the thickness thereof and extending between said opposed first and second surfaces;
a first conductive contact element (32) partially disposed in said aperture, said first contact element (32) comprising a wadded strand of conductive wire and being resiliently deformable when compressed, and
a second conductive contact element (34) having a base portion (34b) disposed within said aperture and a terminal portion (34t) providing a contact surface facing away from said base portion (34b), said second contact element (34) and said aperture being in mating engagement for axially guided reciprocal movement of the second contact element (34) in said aperture;
wherein the base portion (34b) of the second contact element (34) is in engagement with the first contact element (32), wherein said contact surface of the second contact element (34) extends outwardly from said second housing means surface when the first contact element (32) is in its uncompressed state, and wherein said first contact element (32) is resiliently compressible to permit forced resilient retraction of the second contact element (34) into substantially coplanar relation of its contact surface with said second housing means surface.

2. The electrical connector of claim 1 in combination with a socket (14) for mounting an integrated circuit chip carrier (12) having a plurality of peripherally mounted contact pads (26) for circuit testing; said dielectric housing means (16, 18) being disposed on the bottom of said socket whereby portions of second contact elements mounted in said connector are urged into engagement with contacts of an integrated circuit chip carrier (12) when mounted in said socket; and means for locating a test circuit board (20) having prearranged traces (30) for engagement with terminal end portions of said first resilient contact elements (32) whereby electrical communication is established between said traces and said chip carrier pads.

3. The electrical connector of claim 1 in combination with a probe card (79) mounted over said first surface of the dielectric housing means (81, 84) and having a plurality of prearranged plated-through openings (80) at which a plurality of prearranged second contact elements (34) of said electrical connector are received in electrical engagement, and a flexible circuit (71) disposed adjacent said second surface of the dielectric housing means and having a plurality of prearranged pads in engagement with terminal ends of certain of said first contact elements (32).

4. The electrical connector of claim 1 in which said dielectric housing means comprises two super-imposed dielectric boards (16, 18) having correspondingly arranged apertures therein; said first contact elements (32) being mounted in apertures of one (18) of said boards; said second contact elements (34) being mounted in the apertures of the other (16) of said boards and being resiliently biased by said first contact elements (32).

5. An electrical connector comprising:
a dielectric housing means (94, 96) having contact elements (32, 34) mounted therein and having opposed first and second surfaces for assembly with opposed conductors (26, 30) for electrical interconnection between said conductors, said housing means (94, 96) having at least one prearranged aperture traversing the thickness thereof and extending between said opposed first and second surfaces;
a first conductive contact element (32) disposed in said aperture, said first contact element (32) comprising a wadded strand of conductive wire and being resiliently deformable when compressed;
a second conductive contact element (34) having a base portion (34b) disposed within said aperture and a terminal portion (34t) providing a contact surface facing away from said base portion (34b), said second contact element (34) and said aperture being in mating engagement for axially guided reciprocal movement of the second contact element (34) in said aperture,
wherein the base portion (34b) of the second contact element (34) is in engagement with the first contact element (32), wherein said contact surface of the second contact element (34) extends outwardly from said second housing means surface when the first contact element (32) is in its uncompressed state, and wherein said first contact element (32) is resiliently compressible to permit forced resilient retraction of the second contact element (34) into substantially coplanar relation of its contact surface with said second housing means surface; and
a third conductive contact element (34) having a base portion (34b) disposed within said aperture and a terminal portion (34t) providing a contact portion facing away from said base portion, said third contact element (34) and said aperture being in mating engagement for axially guided reciprocal movement of the third contact element in the aperture,
wherein the base portion (34b) of the third contact element is in engagement with the first contact element (32) and said contact portion of said third contact element extends outwardly from said first surface of said housing means (94, 96) when the first contact element (32) is in its uncompressed state.

6. The electrical connector of claim 1 or 5 in combination with spaced printed circuit boards (100) having conductive traces (102); said traces being in engagement with terminal plunger-like ends (34t) of said conductive contact elements (34); and means for maintaining said printed circuit boards and housing means (94, 96) in desired vertical alignment relative to each other and in a desired state of compression.

7. The electrical connector of claim 2 in combination with an integrated circuit chip carrier (12) mounted in said socket (14); carrier locating means (38) mounted in corner portions of said socket (14) for desired location of said carrier (12) in said socket, and means (58, 55, 56) for urging said carrier into compressive engagement with said second surface of the dielectric housing means (16, 18).

8. The electrical connector of claim 7 in which the carrier urging means (58, 55, 56) comprises a spring loaded heat sink (58).

9. The electrical connector of claim 1 in which said dielectric housing means comprises discrete dielectric boards (16, 18); one of said boards (18) having said first contact elements (32) mounted therein and another of said boards (16) mounting said second contact elements (34) therein.

10. The electrical connector of claim 9 in which said dielectric board (18) having said first contact elements (32) mounted therein has latching means (48) attached to peripheral portions thereof for snap engagement with mating portions (46) of said socket (14).

11. The electrical connector of claim 9 in which the apertures of the boards (16, 18) in which the first contact elements (32) are disposed are chamfered at aperture openings from which such resilient contact elements project for preventing mushrooming of the resilient contact elements exteriorly of the apertures.

12. The electrical connector of claim 1 or 9 in which the first contact elements (32) are free of excessive frictional engagement with the aperture peripheries in which disposed and function as resilient springs.

13. The electrical connector of claim 1 wherein said dielectric housing means (16, 18) is disposed on the bottom of a socket (14) for mounting an integrated circuit chip carrier (12) whereby a portion (34t) of said second contact element (34) is urged into engagement with a contact (26) of an integrated circuit chip carrier (12) when mounted in said socket (14).

14. The electrical connector of claim 13 further in combination with an integrated circuit chip carrier (12) mounted in said socket (62), carrier locating means (64) mounted about the periphery of said socket for desired location of said carrier in said socket, and means (63) for urging said carrier (12) into compressive engagement with said dielectric housing means (67).

15. The electrical connector of claim 14 wherein the carrier urging means comprises a retention spring (63).

16. The electrical connector of claim 1 wherein said contact surface of said second contact element (34) is adapted to effect a point-like contact.

17. The electrical connector of claim 5 wherein the first contact element (32) is sufficiently compressible whereby the terminal ends (34t) of said second and third conductive contact elements (34) may be simultaneously urged into coplanar relationship with said opposed surfaces of said housing means (94, 96) by resilient deformation of said first contact element (32).

18. The electrical connector of claim 1 wherein said first conductive contact element (32) is projecting from the first surface of the housing means (16, 18) for effecting electrical contact with a pad (30).

19. The electrical connector of claim 1 or 5 wherein said housing means (16, 18; 94, 96) has an array of apertures traversing the thickness thereof whereby said first and second conductive contact elements (32, 34) in each of said apertures of said array provide yieldable compressive electric contact with contact pads or traces (26, 30; 102) disposed at each of said openings of said array of apertures for establishing electric paths through said dielectric housing means (16, 18; 94, 96) and between such contact pads or traces arranged in various locations at said aperture openings.

20. The electrical connector of claim 19 in which said apertures extending through said housing means (16, 18; 94, 96) are formed in a grid array.

21. The electrical connector of claim 1 or 19 wherein said dielectric housing means is a socket body (62) for mounting an integrated circuit chip carrier (12).

22. The electrical connector of claim 21 further comprising means (63) for urging the carrier (12) into engagement with the housing means (62).

23. The connector of claim 22 wherein the urging means includes a retention spring (63).

24. The electrical connector of claim 21 further comprising means (63, 64) for locating the carrier (12) in the socket body (62).

25. The electrical connector of claim 24 further including a retention spring (63).

26. The electrical connector of claim 5 wherein said first contact element (32) is between said second contact element (34) and said third contact element (34).

## Patentansprüche

1. Elektrischer Verbinder, umfassend:
eine dielektrische Gehäuseanordnung (16, 18), die darin angeordnete Kontaktelemente (32, 34) aufweist und eine erste und eine zweite Oberfläche, welche einander gegenüberliegen, zum Zusammenbau mit einander gegenüberliegenden Leitern (26, 30) für eine elektrische Verbindung zwischen den Leitern aufweist, wobei die Gehäuseanordnung (16, 18) mindestens eine vorher angeordnete Öffnung aufweist, welche deren Dicke durchsetzt und sich zwischen der ersten und der zweiten Oberfläche, die einander gegenüberliegen, erstreckt;
ein erstes leitfähiges Kontaktelement (32), das teilweise in der Öffnung angeordnet ist, wobei das erste Kontaktelement (32) ein bauschförmiges Bündel aus leitfähigem Draht umfaßt und elastisch verformbar ist, wenn es zusammengedrückt wird, und
ein zweites leitfähiges Kontaktelement (34), das einen innerhalb der Öffnung angeordneten Basisbereich (34b) und einen Anschlußbereich (34t), welcher eine dem Basisbereich (34b) abgewandte Kontaktoberfläche bereitstellt, aufweist, wobei das zweite Kontaktelement (34) und die Öffnung zu einer axial geführten Hin- und Herbewegung des zweiten Kontaktelements (34) in der Öffnung in zusammenpassendem Eingriff stehen;
wobei der Basisbereich (34b) des zweiten Kontaktelements (34) in Kontakt mit dem ersten Kontaktelement (32) steht, wobei die Kontaktoberfläche des zweiten Kontaktelements (34) sich von der zweiten Gehäuseanordnungsoberfläche nach außen erstreckt, wenn das erste Kontaktelement (32) sich in seinem nicht zusammengedrückten Zustand befindet, und wobei das erste Kontaktelement (32) so elastisch zusammendrückbar ist, daß es ein erzwungenes elastisches Zurückziehen des zweiten Kontaktelements (34) in eine im wesentlichen mit der zweiten Gehäuseanordnungsoberfläche koplanare Stellung seiner Kontaktoberfläche erlaubt.

2. Elektrischer Verbinder nach Anspruch 1 in Kombination mit einer Fassung (14) zum Halten eines Integrierte-Schaltung-Chip-Trägers (12), der mehrere am Rande angeordnete Kontaktflächen (26) zur Schaltungsprüfung aufweist; wobei die dielektrische Gehäuseanordnung (16, 18) auf dem Boden der Fassung angeordnet ist, wodurch in dem Verbinder angeordnete Bereiche der zweiten Kontaktelemente in Berührung mit Kontakten eines Integrierte-Schaltung-Chip-Trägers (12) gedrängt werden, wenn er in der Fassung gehalten ist; und mit Mitteln zum Festlegen einer Prüf-Leiterplatte (20), die vorher angeordnete Leiterbahnen (30) zum Inkontaktbringen mit Anschlußendbereichen der ersten elastischen Kontaktelemente (32) aufweist, wodurch eine elektrische Kommunikation zwischen den Leiterbahnen und den Chip-Träger-Flächen eingerichtet wird.

3. Elektrischer Verbinder nach Anspruch 1 in Kombination mit einer Prüfkarte (79), die über der ersten Oberfläche der dielektrischen Gehäuseanordnung (81, 84) angeordnet ist und mehrere vorher angeordnete durchkontaktierte Öffnungen (80) aufweist, an denen mehrere vorher angeordnete zweite Kontaktelemente (34) des elektrischen Verbinders in elektrischem Eingriff aufgenommen werden, und einer flexiblen Schaltung (71), die benachbart zu der zweiten Oberfläche der dielektrischen Gehäuseanordnung angeordnet ist und mehrere vorher angeordnete Flächen aufweist, die mit Anschlußenden von bestimmten der ersten Kontaktelemente (32) in Kontakt stehen.

4. Elektrischer Verbinder nach Anspruch 1, bei dem die dielektrische Gehäuseanordnung zwei übereinander angeordnete dielektrische Platten (16, 18) umfaßt, welche darin einander entsprechend angeordnete Öffnungen aufweisen; wobei die ersten Kontaktelemente (32) in Öffnungen einer (18) der Platten angeordnet sind und die zweiten Kontaktelemente (34) in den Öffnungen der anderen (16) der Platten angeordnet sind und durch die ersten Kontaktelemente (32) elastisch vorgespannt sind.

5. Elektrischer Verbinder, umfassend:
eine dielektrische Gehäuseanordnung (94, 96), die darin angeordnete Kontaktelemente (32, 34) aufweist und eine erste und eine zweite Oberfläche, welche einander gegenüberliegen, zum Zusammenbau mit einander gegenüberliegenden Leitern (26, 30) für eine elektrische Verbindung zwischen den Leitern aufweist, wobei die Gehäuseanordnung (94, 96) mindestens eine vorher angeordnete Öffnung aufweist, welche deren Dicke durchsetzt und sich zwischen der ersten und der zweiten Oberfläche, die einander gegenüberliegen, erstreckt;
ein erstes leitfähiges Kontaktelement (32), das in der Öffnung angeordnet ist, wobei das erste Kontaktelement (32) ein bauschförmiges Bündel aus leitfähigem Draht umfaßt und elastisch verformbar ist, wenn es zusammengedrückt wird;
ein zweites leitfähiges Kontaktelement (34), das einen innerhalb der Öffnung angeordneten Basisbereich (34b) und einen Anschlußbereich (34t), welcher eine dem Basisbereich (34b) abgewandte Kontaktoberfläche bereitstellt, aufweist, wobei das zweite Kontaktelement (34) und die Öffnung zu einer axial geführten Hin- und Herbewegung des zweiten Kontaktelements (34) in der Öffnung in zusammenpassendem Eingriff stehen,
wobei der Basisbereich (34b) des zweiten Kontaktelements (34) in Kontakt mit dem ersten Kontaktelement (32) steht, wobei die Kontaktoberfläche des zweiten Kontaktelements (34) sich von der zweiten Gehäuseanordnungsoberfläche nach außen erstreckt, wenn das erste Kontaktelement (32) sich in seinem nicht zusammengedrückten Zustand befindet, und wobei das erste Kontaktelement (32) so elastisch zusammendrückbar ist, daß es ein erzwungenes elastisches Zurückziehen des zweiten Kontaktelements (34) in eine im wesentlichen mit der zweiten Gehäuseanordnungsoberfläche koplanare Stellung seiner Kontaktoberfläche erlaubt; und
ein drittes leitfähiges Kontaktelement (34), das einen innerhalb der Öffnung angeordneten Basisbereich (34b) und einen Anschlußbereich (34t), welcher einen dem Basisbereich abgewandten Kontaktbereich bereitstellt, aufweist, wobei das dritte Kontaktelement (34) und die Öffnung zu einer axial geführten Hin- und Herbewegung des dritten Kontaktelements in der Öffnung in zusammenpassendem Eingriff stehen,
wobei der Basisbereich (34b) des dritten Kontaktelements in Kontakt mit dem ersten Kontaktelement (32) steht und der Kontaktbereich des dritten Kontaktelements sich von der ersten Oberfläche der Gehäuseanordnung (94, 96) nach außen erstreckt, wenn das erste Kontaktelement (32) sich in seinem nicht zusammengedrückten Zustand befindet.

6. Elektrischer Verbinder nach Anspruch 1 oder 5 in Kombination mit voneinander beabstandeten gedruckten Schaltungen (100), die leitfähige Leiterbahnen (102) aufweisen; wobei die Leiterbahnen in Kontakt mit kolbenartigen Anschlußenden (34t) der leitfähigen Kontaktelemente (34) stehen; und mit Mitteln zum Halten der gedruckten Schaltungen und der Gehäuseanordnung (94, 96) in einer gewünschten vertikalen Ausrichtung relativ zueinander und in einem gewünschten Zusammendrückzustand.

7. Elektrischer Verbinder nach Anspruch 2 in Kombination mit einem Integrierte-Schaltung-Chip-Träger (12), der in der Fassung (14) gehalten ist; mit Träger-Haltemitteln (38), die in Eckbereichen der Fassung (14) zum gewünschten Halten des Trägers (12) in der Fassung angeordnet sind, und Mitteln (58, 55, 56) zum Drängen des Trägers in Zusammendrückkontakt mit der zweiten Oberfläche der dielektrischen Gehäuseanordnung (16, 18).

8. Elektrischer Verbinder nach Anspruch 7, bei dem das Träger-Drängmittel (58, 55, 56) eine federbeaufschlagte Wärmesenke (58) umfaßt.

9. Elektrischer Verbinder nach Anspruch 1, bei dem die dielektrische Gehäuseanordnung getrennte dielektrische Platten (16, 18) umfaßt; wobei in einer der Platten (18) die ersten Kontaktelemente (32) angeordnet und in einer anderen der Platten (16) die zweiten Kontaktelemente (34) angeordnet sind.

10. Elektrischer Verbinder nach Anspruch 9, bei dem die dielektrische Platte (18), in der die ersten Kontaktelemente (32) angeordnet sind, Rastmittel (48) aufweist, die an Randbereichen derselben für einen Schnappeingriff mit zusammenpassenden Bereichen (46) der Fassung (14) angebracht sind.

11. Elektrischer Verbinder nach Anspruch 9, bei dem die Öffnungen der Platten (16, 18), in welchen die ersten Kontaktelemente (32) angeordnet sind, an Öffnungsmündungen, von welchen solche elastischen Kontaktelemente vorstehen, abgeschrägt sind, um eine pilzförmige Verformung der elastischen Kontaktelemente außerhalb der Öffnungen zu verhindern.

12. Elektrischer Verbinder nach Anspruch 1 oder 9, bei dem die ersten Kontaktelemente (32) von übermäßigem Reibungskontakt mit den Öffnungsrändern, in welchen sie angeordnet sind, frei sind und als elastische Federn wirken.

13. Elektrischer Verbinder nach Anspruch 1, wobei die dielektrische Gehäuseanordnung (16, 18) auf dem Boden einer Fassung (14) zum Halten eines Integrierte-Schaltung-Chip-Trägers (12) angeordnet ist, wodurch ein Bereich (34t) des zweiten Kontaktelements (34) in Berührung mit einem Kontakt (26) eines Integrierte-Schaltung-Chip-Trägers (12) gedrängt wird, wenn er in der Fassung (14) gehalten ist.

14. Elektrischer Verbinder nach Anspruch 13, ferner in Kombination mit einem Integrierte-Schaltung-Chip-Träger (12), der in der Fassung (62) gehalten ist, einem Träger-Festlegemittel (64), das um den Rand der Fassung für ein gewünschtes Festlegen des Trägers in der Fassung angeordnet ist, und einem Mittel (63) zum Drängen des Trägers (12) in Zusammendrückkontakt mit der dielektrischen Gehäuseanordnung (67).

15. Elektrischer Verbinder nach Anspruch 14, wobei das Träger-Drängmittel eine Rückhaltefeder (63) umfaßt.

16. Elektrischer Verbinder nach Anspruch 1, wobei die Kontaktoberfläche des zweiten Kontaktelements (34) zum Bewirken eines punktförmigen Kontakts ausgebildet ist.

17. Elektrischer Verbinder nach Anspruch 5, wobei das erste Kontaktelement (32) ausreichend zusammendrückbar ist, wodurch die Anschlußenden (34t) des zweiten und des dritten leitfähigen Kontaktelements (34) gleichzeitig durch elastische Verformung des ersten Kontaktelements (32) in eine mit den einander gegenüberliegenden Oberflächen der Gehäuseanordnung (94, 96) koplanare Stellung gedrängt werden können.

18. Elektrischer Verbinder nach Anspruch 1, wobei das erste leitfähige Kontaktelement (32) von der ersten Oberfläche der Gehäuseanordnung (16, 18) zum Bewirken eines elektrischen Kontakts mit einer Fläche (30) vorsteht.

19. Elektrischer Verbinder nach Anspruch 1 oder 5, wobei die Gehäuseanordnung (16, 18; 94, 96) eine regelmäßige Anordnung von Öffnungen aufweist, welche deren Dicke durchsetzen, wodurch das erste und das zweite leitfähige Kontaktelement (32, 34) in jeder der Öffnungen der regelmäßigen Anordnung einen nachgiebigen elektrischen Zusammendrückkontakt mit Kontaktflächen oder Leiterbahnen (26, 30; 102), die an jeder der Mündungen der regelmäßigen Anordnung von Öffnungen angeordnet sind, zum Einrichten elektrischer Pfade durch die dielektrische Gehäuseanordnung (16, 18; 94, 96) und zwischen solchen Kontaktflächen oder Leiterbahnen, die an verschiedenen Stellen an den Öffnungsmündungen angeordnet sind, bereitstellen.

20. Elektrischer Verbinder nach Anspruch 19, bei dem die Öffnungen, die sich durch die Gehäuseanordnung (16, 18; 94, 96) erstrecken, in einer regelmäßigen Gitteranordnung ausgebildet sind.

21. Elektrischer Verbinder nach Anspruch 1 oder 19, wobei die dielektrische Gehäuseanordnung ein Fassungskörper (62) zum Halten eines Integrierte-Schaltung-Chip-Trägers (12) ist.

22. Elektrischer Verbinder nach Anspruch 21, der ferner ein Mittel (63) zum Drängen des Trägers (12) in Kontakt mit der Gehäuseanordnung (62) umfaßt.

23. Elektrischer Verbinder nach Anspruch 22, wobei das Drängmittel eine Rückhaltefeder (63) umfaßt.

24. Elektrischer Verbinder nach Anspruch 21, der ferner Mittel (63, 64) zum Festlegen des Trägers (12) in dem Fassungskörper (62) umfaßt.

25. Elektrischer Verbinder nach Anspruch 24, der ferner eine Rückhaltefeder (63) umfaßt.

26. Elektrischer Verbinder nach Anspruch 5, wobei das erste Kontaktelement (32) zwischen dem zweiten Kontaktelement (34) und dem dritten Kontaktelement (34) angeordnet ist.

## Revendications

1. Connecteur électrique comprenant :
◆ des moyens formant logement diélectrique (16, 18) dans lesquels des éléments de contact (32, 34) sont montés et comportant des première et seconde surfaces opposées pour l'assemblage avec des conducteurs opposés (26, 30) pour une interconnexion électrique entre lesdits conducteurs, lesdits moyens formant logement (16, 18) comportant au moins un trou préagencé traversant l'épaisseur de ceux-ci et s'étendant entre lesdites première et seconde surfaces opposées ;
◆ un premier élément de contact conducteur (32) disposé partiellement dans ledit trou, ledit premier élément de contact (32) comprenant un tampon de fil conducteur et étant élastiquement déformable lorsqu'il est comprimé, et
◆ un second élément de contact conducteur (34) comportant une partie de base (34b), disposée à l'intérieur dudit trou, et une partie terminale (34t) fournissant une surface de contact orientée à l'opposé de ladite partie de base (34b), ledit second élément de contact (34) et ledit trou étant en prise d'accouplement pour le mouvement de va et vient guidé axialement du second élément de contact (34) dans ledit trou ;
◆ dans lequel la partie de base (34b) du second élément de contact (34) est en prise avec le premier élément de contact (32), dans lequel ladite surface de contact du second élément de contact (34) s'étend vers l'extérieur depuis ladite seconde surface des moyens formant logement lorsque le premier élément de contact (32) est dans son état non compressé, et dans lequel ledit premier élément de contact (32) est compressible de manière élastique pour permettre la rétraction élastique forcée du second élément de contact (34) de sorte que sa surface de contact soit dans une relation sensiblement coplanaire avec ladite seconde surface des moyens formant logement.

2. Connecteur électrique selon la revendication 1 en combinaison avec un réceptacle (14) pour monter un support de puce de circuit intégré (12) comportant une pluralité de pastilles de contact (26) montées de manière périphérique pour tester des circuits ; lesdits moyens formant logement diélectrique (16, 18) étant disposés sur le fond dudit réceptacle, de telle manière que des parties des seconds éléments de contact montés dans ledit connecteur soient poussées en prise avec les contacts d'un support de puce de circuit intégré (12) en position montée dans ledit réceptacle ; et des moyens pour situer une carte de circuit de test (20) comportant des pistes préagencées (30) pour une mise en prise avec des parties d'extrémité terminales desdits premiers éléments de contact élastique (32), de telle manière qu'une communication électrique soit établie entre lesdites pistes et lesdites pastilles de support de puce.

3. Connecteur électrique selon la revendication 1 en combinaison avec une carte de sonde (79) montée sur ladite première surface des moyens formant logement diélectrique (81, 84) et comportant une pluralité d'ouvertures débouchantes métallisées préagencées (80) dans lesquelles une pluralité de seconds éléments de contact préagencés (34) dudit connecteur électrique sont reçus dans une mise en prise électrique, et un circuit flexible (71) disposé contigu à ladite seconde surface des moyens formant logement diélectrique et comportant une pluralité de pastilles préagencées en prise avec des extrémités terminales de certains desdits premiers éléments de contact (32).

4. Connecteur électrique selon la revendication 1, dans lequel lesdits moyens formant logement diélectrique comprennent deux cartes diélectriques superposées (16, 18) dans lesquelles des trous sont agencés de manière correspondante; lesdits premiers éléments de contact (32) étant montés dans les trous d'une (18) desdites cartes ; lesdits seconds éléments de contact (34) étant montés dans les trous de l'autre (16) desdites cartes et étant sollicités de manière élastique par lesdits premiers éléments de contact (32).

5. Connecteur électrique comprenant :
◆ des moyens formant logement diélectrique (94, 96) dans lesquels des éléments de contact (32, 34) sont montés et comportant des première et seconde surfaces opposées pour l'assemblage avec des conducteurs opposés (26, 30) pour une interconnexion électrique entre lesdits conducteurs, lesdits moyens formant logement (94, 96) comportant au moins un trou préagencé traversant l'épaisseur de ceux-ci et s'étendant entre lesdites première et seconde surfaces opposées ;
◆ un premier élément de contact conducteur (32) disposé dans ledit trou, ledit premier élément de contact (32) comprenant un tampon de fil conducteur et étant élastiquement déformable lorsqu'il est comprimé ;
◆ un second élément de contact conducteur (34) comportant une partie de base (34b) disposée dans ledit trou et une partie terminale (34t) fournissant une surface de contact orientée à l'opposé de ladite partie de base (34b), ledit second élément de contact (34) et ledit trou étant en prise d'accouplement pour le mouvement de va et vient guidé axialement du second élément de contact (34) dans ledit trou,
◆ dans lequel la partie de base (34b) du second élément de contact (34) est en prise avec le premier élément de contact (32), dans lequel ladite surface de contact du second élément de contact (34) s'étend vers l'extérieur depuis ladite seconde surface des moyens formant logement lorsque le premier élément de contact (32) est dans son état non comprimé, et dans lequel ledit premier élément de contact (32) est compressible de manière élastique pour permettre la rétraction élastique forcée du second élément de contact (34) de sorte que sa surface de contact soit dans une relation sensiblement coplanaire avec ladite seconde surface des moyens formant logement ; et
◆ un troisième élément de contact conducteur (34) comportant une partie de base (34b) disposée dans ledit trou et une partie terminale (34t) fournissant une partie de contact orientée à l'opposé de ladite partie de base, ledit troisième élément de contact (34) et ledit trou étant en prise d'accouplement pour le mouvement de va et vient guidé axialement du troisième élément de contact dans le trou,
◆ dans lequel la partie de base (34b) du troisième élément de contact est en prise avec le premier élément de contact (32) et ladite partie de contact dudit troisième élément de contact s'étend vers l'extérieur depuis ladite première surface desdits moyens formant logement (94, 96) lorsque le premier élément de contact (32) est dans son état non comprimé.

6. Connecteur électrique selon la revendication 1 ou 5 en combinaison avec des cartes de circuit imprimé espacées (100) comportant des pistes conductrices (102); lesdites pistes étant en prise avec des extrémités terminales semblables à des pistons (34t) desdits éléments de contact conducteurs (34); et des moyens pour maintenir lesdites cartes de circuit imprimé et lesdits moyens formant logement (94, 96) dans l'alignement vertical souhaité les uns par rapport aux autres et dans un état souhaité de compression.

7. Connecteur électrique selon la revendication 2 en combinaison avec un support de puce de circuit intégré (12) monté dans ledit réceptacle (14); des moyens de situation de support (38) montés dans des parties d'angle dudit réceptacle (14) pour situer de manière souhaitée ledit support (12) dans ledit réceptacle, et des moyens (58, 55, 56) pour pousser ledit support en prise par compression avec ladite seconde surface des moyens formant logement diélectrique (16, 18).

8. Connecteur électrique selon la revendication 7, dans lequel les moyens de poussée de support (58, 55, 56) comprennent un dissipateur de chaleur sous l'action d'un ressort (58).

9. Connecteur électrique selon la revendication 1, dans lequel lesdits moyens formant logement diélectrique comprennent des cartes diélectriques discrètes (16, 18); lesdits premiers éléments de contact (32) étant montés dans l'une (18) desdites cartes et lesdits seconds éléments de contact (34) étant montés dans une autre (16) desdites cartes.

10. Connecteur électrique selon la revendication 9, dans lequel ladite carte diélectrique (18), dans laquelle lesdits premiers éléments de contact (32) sont montés, comprend des moyens de verrouillage (48) fixés à ses parties périphériques pour une mise en prise de verrouillage à crans avec les parties correspondantes (46) dudit réceptacle (14).

11. Connecteur électrique selon la revendication 9, dans lequel les trous des cartes (16, 18), dans lesquelles les premiers éléments de contact (32) sont disposés, sont chanfreinés au niveau des ouvertures de trous à partir desquelles ces éléments de contact élastique s'étendent pour empêcher l'aplatissement des éléments de contact élastique à l'extérieur des trous.

12. Connecteur électrique selon la revendication 1 ou 9, dans lequel les premiers éléments de contact (32) sont exempts de mise en prise par friction excessive avec les périphéries des trous dans lesquels ils sont disposés et fonctionnent comme des ressorts élastiques.

13. Connecteur électrique selon la revendication 1, dans lequel lesdits moyens formant logement diélectrique (16, 18) sont disposés sur le fond d'un réceptacle (14) pour monter un support de puce de circuit intégré (12) de telle manière qu'une partie (34t) dudit second élément de contact (34) soit poussée en prise avec un contact (26) d'un support de puce de circuit intégré (12) lorsqu'il est monté dans ledit réceptacle (14).

14. Connecteur électrique selon la revendication 13 en combinaison, de plus, avec un support de puce de circuit intégré (12) monté dans ledit réceptacle (62), des moyens de situation de support (64) montés autour de la périphérie dudit réceptacle pour situer de manière souhaitée ledit support dans ledit réceptacle, et des moyens (63) pour pousser ledit support (12) en prise par compression avec lesdits moyens formant logement diélectrique (67).

15. Connecteur électrique selon la revendication 14, dans lequel les moyens de poussée de support comprennent un ressort de maintien (63).

16. Connecteur électrique selon la revendication 1, dans lequel ladite surface de contact dudit second élément de contact (34) est susceptible d'établir un contact ponctuel.

17. Connecteur électrique selon la revendication 5, dans lequel le premier élément de contact (32) est suffisamment compressible, de telle manière que les extrémités terminales (34t) desdits second et troisième éléments de contact conducteurs (34) puissent être simultanément poussées dans une relation coplanaire avec lesdites surfaces opposées desdits moyens formant logement (94, 96) par déformation élastique dudit premier élément de contact (32).

18. Connecteur électrique selon la revendication 1, dans lequel ledit premier élément de contact conducteur (32) déborde de la première surface des moyens formant logement (16, 18) pour établir un contact électrique avec une pastille (30).

19. Connecteur électrique selon la revendication 1 ou 5, dans lequel lesdits moyens formant logement (16, 18; 94, 96) comprennent un réseau de trous traversant l'épaisseur de ceux-ci, de telle manière que lesdits premier et second éléments de contact conducteurs (32, 34) dans chacun desdits trous dudit réseau assurent un contact électrique compressible susceptible d'être généré avec des pastilles ou des pistes de contact (26, 30 ; 102) disposées à chacune desdites ouvertures dudit réseau de trous pour établir des trajets électriques à travers lesdits moyens formant logement diélectrique (16, 18; 94, 96) et entre ces pastilles ou ces pistes de contact agencées en divers emplacements au niveau desdites ouvertures des trous.

20. Connecteur électrique selon la revendication 19, dans lequel lesdits trous s'étendant à travers lesdits moyens formant logement (16, 18; 94, 96) sont formés en un réseau de grille.

21. Connecteur électrique selon la revendication 1 ou 19, dans lequel lesdits moyens formant logement diélectrique sont un corps de réceptacle (62) pour monter un support de puce de circuit intégré (12).

22. Connecteur électrique selon la revendication 21, comprenant, de plus, des moyens (63) pour pousser le support (12) en prise avec les moyens formant logement (62).

23. Connecteur selon la revendication 22, dans lequel les moyens de poussée comprennent un ressort de maintien (63).

24. Connecteur électrique selon la revendication 21, comprenant, de plus, des moyens (63, 64) pour positionner le support (12) dans le corps de réceptacle (62).

25. Connecteur électrique selon la revendication 24, comprenant, de plus, un ressort de maintien (63).

26. Connecteur électrique selon la revendication 5, dans lequel ledit premier élément de contact (32) se trouve entre ledit second élément de contact (34) et ledit troisième élément de contact (34).
